# EUROPEAN PATENT SPECIFICATION

(11) **EP 4 399 573 B1**
(45) Date of publication and mention of the grant of the patent: **01.10.2025**
(21) Application number: 22768710.0
(22) Date of filing: 22.08.2022
(51) Int. Cl.: G03F 7/00, G01B 15/04, G06N 3/045, G06N 3/0475, G06N 3/094, H01J 37/22, G06N 3/088

(54) **METHOD FOR CONVERTING METROLOGY DATA**
VERFAHREN ZUR KONVERTIERUNG VON METROLOGIEDATEN
PROCÉDÉ DE CONVERSION DE DONNÉES DE MÉTROLOGIE

(30) Priority: 09.09.2021 WO PCT/CN2021/117420
(43) Date of publication of application: 17.07.2024
(73) Proprietor: ASML Netherlands B.V., 5500 AH Veldhoven (NL)
(72) Inventor: GUO, Yunbo, San Jose, California 95134-1720 (US); WANG, Zhu, San Jose, California 95134-1720 (US); YANG, Feng, 5500 AH Veldhoven (NL); ZHAO, Qian, San Jose, California 95134-1720 (US); FENG, Mu, San Jose, California 95134-1720 (US); WANG, Jen-Shiang, San Jose, California 95134-1720 (US)
(74) Representative: ASML Netherlands B.V.
(86) International application number: PCT/EP2022/073343
(87) International publication number: WO 2023/036593

(56) References cited:
- EP-A1- 3 579 052
- US-A1- 2007 135 959
- US-A1- 2016 141 193
- US-B1- 7 361 941

## Description

### CROSS-REFERENCE TO RELATED APPLICATIONS

This application claims priority of International application PCT/CN2021/117420 which was filed on September 9, 2021.

### TECHNICAL FIELD

The description herein relates generally to processing metrology data acquired by a metrology system, and more particularly, related to processing the metrology data using a machine learning model.

### BACKGROUND

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatuses, the pattern on the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices as described herein can be gleaned, for example, from US 6,046,792. Examples of other prior art documents are EP3579052A1; US2016/141193A1; US2007/135959A1; and US7361941B1.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

### SUMMARY

In semiconductor manufacturing, multiple metrology tools operating on similar measurement principles or similar mechanism of signal generation from a patterned substrate may be employed. For example, multiple scanning electron microscopes (SEMs) determining measurements based on electron-beam interaction with a patterned substrate may be used during semiconductor manufacturing. Multiple metrology systems may be used to improve metrology throughput, measurement accuracy, cost-efficiencies, or for other reasons. The measurements may be employed to improve a patterning process, for example. Although similar in operation, one metrology systems may differ from another metrology system in various aspects, such as mechanical sub-systems, electrical sub-systems, electronics, signal detection, image acquisition algorithms, image processing algorithms, contour extraction algorithms, or other structures and software. As such, using multiple metrology systems may lead to inconsistent measurement results of same patterns on the same substrate. The present disclosure provides mechanisms to convert metrology data (e.g., SEM images or contours) obtained from a particular metrology tool using a trained machine learning model. This converted metrology data matches to or is comparable to another metrology tool (e.g., a reference metrology system) thereby allowing measurement consistency between different metrology tools. For example, the converted have signal and/or CD associated with features of the patterned substrate that matches signal and/or CD acquired by another metrology tool. In other words, the converted metrology data or measurements derived from the converted metrology data is comparable to acquiring metrology data or measurements using another metrology tool.

The metrology systems are multiple scanning electron microscopes (SEM). In an embodiment, the mechanisms herein include training a machining learning (ML) model to convert SEM images acquired by one SEM system to images as if acquired by another SEM system. Thus, measurements of physical characteristics of patterned features performed on the converted images will be like performing measurements on images acquired by the other SEM system. In an embodiment, differences (e.g., CD mismatch and/or SEM image mismatch) between measurement data from different tools may be incorporated in a cost function training the ML model. In an example, measurement data including SEM signals may be used to guide image conversion. Furthermore, the mechanism involves obtaining measurement settings (e.g., CD measurement settings) using training data and applying it to the converted images to obtain measurements (e.g., CDs) associated with the patterned substrate. These measurements will be as if acquired by another SEM system (e.g., the reference SEM system).

In an embodiment, a method for training a machine learning model and using the trained machine learning model for converting metrology data is provided. The method include accessing a first SEM data set acquired by a first scanning electron metrology (SEM) system and a second SEM data set acquired by a second SEM system, where the first SEM data set and the second SEM data set is associated with a patterned substrate. Using the first SEM data set and the second SEM data set as training data, a machine learning (ML) model is trained such that the trained ML model is configured to convert a metrology data set acquired by the second SEM system to a converted data set having characteristics comparable to metrology data being acquired by the first SEM system.

In an embodiment, the first SEM data set and the second SEM data set may be a set of images of the patterned substrate, contours of features on the patterned substrate, physical characteristics associated with patterns on the patterned substrates, or a combination thereof. In an embodiment, the physical characteristics comprises critical dimension (CD) of the patterns on the patterned substrate.

In an embodiment, training the ML model involves comparing the first SEM data set and the second SEM data set; and adjusting parameters of the ML model based on the comparison to influence a cost function used to train the ML model.

In an embodiment, training the ML model involves signal-to-signal matching or CD-to-CD matching. For example, training the ML model involves comparing first CD values of the first SEM data set and second CD values of the second SEM data set; and adjusting parameters of the ML model based on the comparison to influence a cost function used to train the ML model to improve CD matching between the first and the second SEM data sets, the cost function being a function of the first CD values and the second CD values.

In an embodiment, the method may further involve receiving a metrology measurement recipe for the metrology system based on a first SEM data set and physical characteristic measurements of the substrate from the first SEM system; and applying the metrology measurement recipe to the converted metrology data to determine another physical characteristics measurements. In an embodiment, the metrology measurement recipe comprises CD thresholding values indicative of locations on the captured metrology data where CD measurements be taken.

In an embodiment, determining the metrology measurement recipe involves extracting, via a first contour extraction algorithm, a contour from an image of the first SEM data set; drawing a cutline at a location across the contour to measure a CD; and determining, based on a signal along the cutline, CD threshold value corresponding to the measured CD.

In an embodiment a metrology system is provided. The metrology system includes a process or a computer system including one or more processors having a trained machine learning (ML) model stored thereon and programmed with computer program instructions that, when executed, cause the computer system to: capture metrology data of a patterned substrate; and convert the captured metrology data via a trained ML model into converted metrology data, the converted metrology data having characteristics as if captured by another metrology system.

According to an embodiment, there is provided a computer system comprising a non-transitory computer readable medium having instructions recorded thereon. The instructions, when executed by a computer, implement the method steps above.

### BRIEF DESCRIPTION OF THE DRAWINGS

The above aspects and other aspects and features will become apparent to those ordinarily skilled in the art upon review of the following description of specific embodiments in conjunction with the accompanying figures, wherein:
Figure 1 shows a block diagram of various subsystems of a lithography system, according to an embodiment;
Figure 2 is an exemplary flowchart of a method for converting images acquired by a particular metrology system to images as if acquired by another metrology system, according to an embodiment;
Figure 3 illustrates exemplary measurement data acquired by a first metrology system and a second metrology system, according to an embodiment;
Figure 4 illustrates signals within a portion of the images acquired in Figure 3, according to an embodiment;
Figure 5 illustrates an exemplary training of the ML model using a generator adversarial network (GAN), according to an embodiment;
Figure 6A illustrates inputting a second image acquired by the second metrology system to a trained model of Figure 2 to generate a converted image, according to an embodiment;
Figure 6B shows an exemplary first image acquired by the first metrology system, the exemplary image is placed adjacent to the converted image of Figure 6A for comparison, according to an embodiment;
Figure 7 illustrates signals within a portion of the first image, the second image and the converted image of Figures 6A and 6B, the signals of the first image and the converted image overlap each other indicating the converted image having similar characteristics as the first image, according to an embodiment;
Figure 8 is a block diagram of exemplary training of a machine learning (ML) model configured to convert an image acquired by the second metrology system to an image as if acquired by the first metrology system, and application of the trained ML model to determine measurements, according to an embodiment;
Figure 9 schematically depicts an embodiment of a scanning electron microscope (SEM), according to an embodiment;
Figure 10 schematically depicts an embodiment of an electron beam inspection apparatus, according to an embodiment; and
Figure 11 is a block diagram of an example computer system, according to an embodiment.

### DETAILED DESCRIPTION

Before describing embodiments in detail, it is instructive to present an example environment in which embodiments may be implemented.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" may be used to encompass all types of electromagnetic radiation, including ultraviolet radiation (e.g., with a wavelength of 365, 248, 193, 157 or 126 nm) and EUV (extreme ultra-violet radiation, e.g., having a wavelength in the range of about 5-100 nm).

The patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. One or more of the design rule limitations may be referred to as "critical dimension" (CD). A critical dimension of a device can be defined as the smallest width of a line or hole or the smallest space between two lines or two holes. Thus, the CD determines the overall size and density of the designed device. Of course, one of the goals in device fabrication is to faithfully reproduce the original design intent on the substrate (via the patterning device).

The pattern layout design may include, as an example, application of resolution enhancement techniques, such as optical proximity corrections (OPC). OPC addresses the fact that the final size and placement of an image of the design layout projected on the substrate will not be identical to, or simply depend only on the size and placement of the design layout on the patterning device. It is noted that the terms "mask", "reticle", "patterning device" are utilized interchangeably herein. Also, person skilled in the art will recognize that, the term "mask," "patterning device" and "design layout" can be used interchangeably, as in the context of RET, a physical patterning device is not necessarily used but a design layout can be used to represent a physical patterning device. For the small feature sizes and high feature densities present on some design layout, the position of a particular edge of a given feature will be influenced to a certain extent by the presence or absence of other adjacent features. These proximity effects arise from minute amounts of radiation coupled from one feature to another or non-geometrical optical effects such as diffraction and interference. Similarly, proximity effects may arise from diffusion and other chemical effects during post-exposure bake (PEB), resist development, and etching that generally follow lithography.

In order to increase the chance that the projected image of the design layout is in accordance with requirements of a given target circuit design, proximity effects may be predicted and compensated for, using sophisticated numerical models, corrections or pre-distortions of the design layout. The article "Full-Chip Lithography Simulation and Design Analysis - How OPC Is Changing IC Design", C. Spence, Proc. SPIE, Vol. 5751, pp 1-14 (2005) provides an overview of current "model-based" optical proximity correction processes. In a typical high-end design almost every feature of the design layout has some modification in order to achieve high fidelity of the projected image to the target design. These modifications may include shifting or biasing of edge positions or line widths as well as application of "assist" features that are intended to assist projection of other features.

An assist feature may be viewed as a difference between features on a patterning device and features in the design layout. The terms "main feature" and "assist feature" do not imply that a particular feature on a patterning device must be labeled as one or the other.

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:
- a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means.
- a programmable LCD array. An example of such a construction is given in U.S. Patent No. 5,229872.

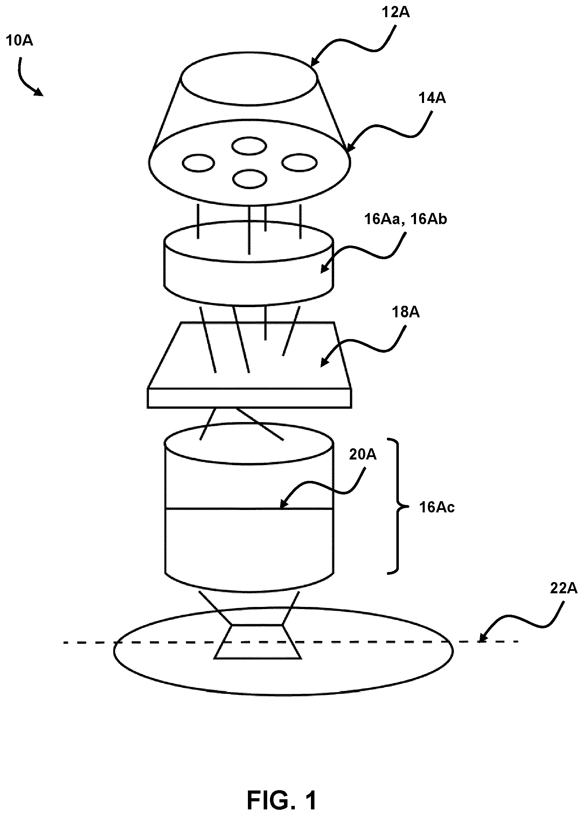

As a brief introduction, Figure 1 illustrates an exemplary lithographic projection apparatus 10A. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, e.g., define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin(Θₘₐₓ), wherein n is the refractive index of the media between the substrate and the last element of the projection optics, and Θₘₐₓ is the largest angle of the beam exiting from the projection optics that can still impinge on the substrate plane 22A.

In a lithographic projection apparatus, a source provides illumination (i.e., radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist layer on the substrate is exposed and the aerial image is transferred to the resist layer as a latent "resist image" (RI) therein. The resist image (RI) can be defined as a spatial distribution of solubility of the resist in the resist layer. A resist model can be used to calculate the resist image from the aerial image, an example of which can be found in U.S. Patent Application Publication No. US 2009-057360. The resist model is related to properties of the resist layer (e.g., effects of chemical processes which occur during exposure, PEB and development). Optical properties of the lithographic projection apparatus (e.g., properties of the source, the patterning device and the projection optics) dictate the aerial image. Since the patterning device used in the lithographic projection apparatus can be changed, it may be desirable to separate the optical properties of the patterning device from the optical properties of the rest of the lithographic projection apparatus including at least the source and the projection optics.

Although specific reference may be made in this text to the use of lithography apparatus in the manufacture of ICs, it should be understood that the lithography apparatus described herein may have other applications, such as the manufacture of integrated optical systems, guidance and detection patterns for magnetic domain memories, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g., having a wavelength of 365, 248, 193, 157 or 126 nm) and extreme ultra-violet (EUV) radiation (e.g., having a wavelength in the range of 5-20 nm), as well as particle beams, such as ion beams or electron beams.

In semiconductor manufacturing, multiple metrology systems operating on similar principles, may be employed for measuring one or more physical characteristics (e.g., CD, EPE, overlay, etc.) of a patterned substrate. Although the operating principles may be similar, the multiple metrology systems differ from another in various aspects such as mechanical sub-systems, electrical sub-systems, electronics, image processing algorithms, contour extraction algorithms, or other structural and software components that may lead to variations in measurements. However, it is desired these measurements of a pattern on the same patterned substrate or different patterned substrates performed using different tools should match. In order to obtain consistent measurements between different metrology systems, metrology data matching to data acquired by a reference (or reference) metrology system may be desired. For example, metrology data of a patterned substrate obtained using a first tool (e.g., a reference metrology system) should match metrology data of the same patterned substrate obtained using a second tool. In this way, the variation caused by tool-to-tool variation is significantly reduced or eliminated from the measurement result variation, and the measurement result variation advantageously and accurately indicates the substrate variation. In an embodiment, the reference metrology system may be of the same supplier, or a different supplier than the second metrology system. For example, the tools may include different process models or designs supplied by different manufacturers or the same manufactures. In some cases, tools may include the same process models but still behave differently, i.e., have tool-to-tool variation.

In existing approaches, after acquiring the metrology data (e.g., SEM images or contours of patterned features), metrology system settings (e.g., tunable parameters of a second metrology tool) may be determined to extract measurements (e.g., CD) from the metrology data. For example, the metrology system settings may be determined to obtain best CD-matching results with CDs obtained using the reference metrology system. In many cases, even if multiple or all available parameters are tuned, the measurements (e.g., CD) matching a specification may not be met. In an embodiment, the metrology settings may include tunable parameters such as dose, field-of-view (FOV), or other parameters of the second metrology tool. In an embodiment, the tunable parameters such as dose, FOV may not be modified to obtain CD-to-CD matching between measurements from the first tool and the second tool. For example, the second metrology tool may use a higher dose, have faster image acquisition speed, or a larger FOV compared to the first metrology tool. These tunable are advantageous for faster metrology measurements. Also, changing such parameters may have a different charging effect causing additional differences in measurements. As such, in an embodiment, the advantageous tunable parameters such as speed and FOV may not be modified, while other parameters such as CD threshold applied during CD measurement from a SEM image may be modified. Thus, while maintaining the advantageous setting of the second metrology system, a matching of measurement results from the first metrology tool may be achieved.

The present disclosure provides mechanisms to convert metrology data (e.g., SEM images or contours) obtained from a second metrology tool using a machine learning model. The converted metrology data match another metrology tool (e.g., the reference metrology system) or comparable to acquiring metrology data from another metrology tool. For example, the mechanisms herein include training a machining learning (ML) model to convert images acquired by one SEM system to images as would be acquired by another SEM system. In an embodiment, the ML model may convert signal, CD values, or other characteristics determined by the SEM systems as would be acquired by another SEM system. Thus, any measurements of physical characteristics of patterned featured performed on the converted images will be comparable to (e.g., matching with) performing measurements on images acquired by the other SEM system. In an embodiment, differences (e.g., CD mismatch and/or SEM image mismatch) between metrology data from different tools may be incorporated in a cost function for training the ML model. As an example, metrology data including SEM image signals (e.g., intensity values) may be used to guide conversion.

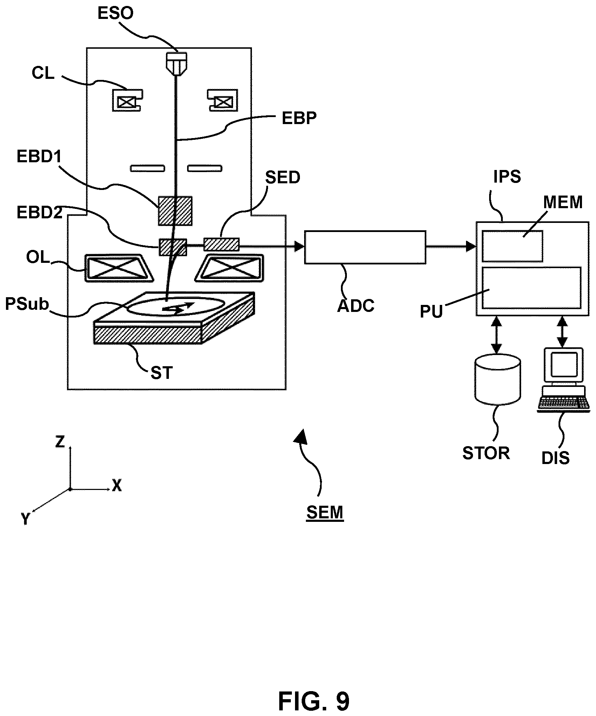

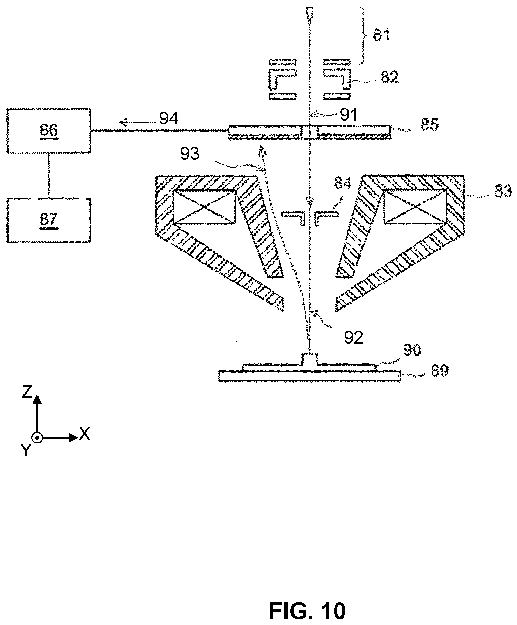

Furthermore, the mechanism involves obtaining measurement settings (e.g., metrology system settings such as CD threshold used to obtain CD measurements) using reference metrology data (e.g., from the reference metrology system). These settings can be applied to the converted images to obtain measurements (e.g., CDs) associated with the patterned substrate so that the measurements are as if acquired by a reference metrology system, for example. In an embodiment, the metrology systems may be different SEM systems e.g., a reference SEM system and another different SEM system. Example metrology systems are illustrated and discussed with respect to Figure 9 and 10. In an embodiment, the mechanisms herein may be employed with images (e.g., SEM images) captured by such metrology systems.

The mechanisms of the present disclosure have several advantages. For example, consistent measurements associated with similar patterns may be obtained using different metrology tools. Even if a metrology tool uses a different algorithm for acquiring measurements, extracting contours from an image, image enhancement to identify feature or contours, image or contour segmentation, image or contour alignment with a reference, deriving measurements, etc., the final measurements obtained after applying the mechanisms herein will provide a close matching to measurements from the reference metrology system. In an embodiment, the matching between first and second metrology data may be characterized by a difference between the first and the second metrology data, statistics associated with the metrology data, intensity values of detection within the metrology data, or other matching parameters. As an example, close matching refers to matching with respect to a difference threshold, reference statistics, reference intensity values, or other ways used for characterizing the matching reference data.

The mechanisms herein may also enable employing different metrology systems for faster production of semiconductor chips, without causing substantial variations in the measurements of a patterned substrate. Thus, adjustments to a patterning process made based on measurements from a reference metrology system may remain substantially the same, thereby maintaining similar production settings of the patterning process to obtain desired throughput.

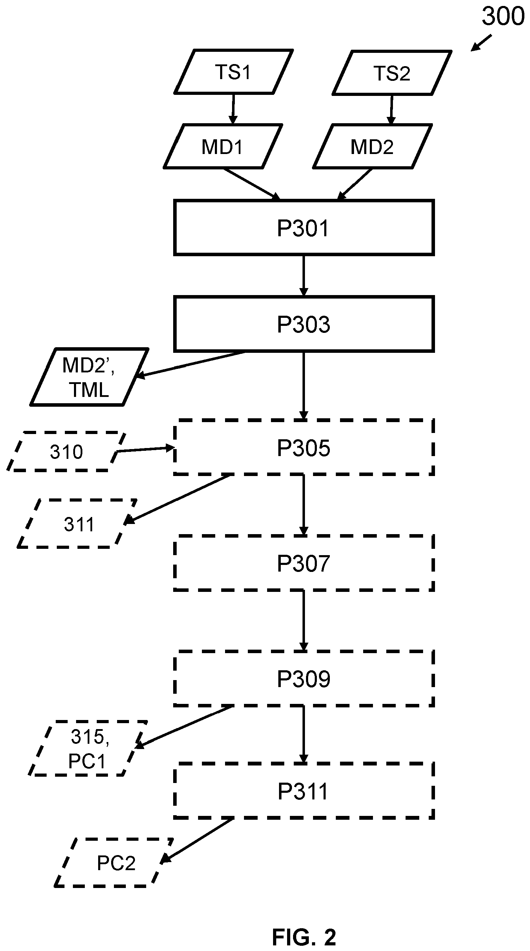

Figure 2 is an exemplary flowchart of a method 300 for converting metrology data acquired by a particular metrology system to metrology data that has characteristics as if acquired by another metrology system, according to an embodiment. In an embodiment, the method 300 involves training a ML model to convert the metrology data. The ML model may be a convolutional neural network (CNN), a deep convolutional neural network (DNN), generative adversarial network (GAN), or other type of neural networks. The training may be based on metrology data sets of the same patterned substrate but acquired by different metrology systems. The ML model learns differences in the metrology data from different systems that may be caused due to unknown algorithms, different measurement recipes, different metrology tool configuration or working principle, etc. Upon training, the trained ML model can predict the metrology data as measured using a different system (e.g., a reference metrology system). Thus, the trained ML model can be advantageously used to improve consistency in measurements of patterned substrates when different metrology systems are used. An exemplary implementation of the method 300 involves processes P301, and P303 for training a ML model. Furthermore, processes P305, P307, P309, and P311 may be included to apply the trained ML model for converting metrology data and predicting measurements of the patterned substrate. The processes are discussed in more detail below.

Process P301 involves acquiring training data from different metrology tools for same patterned substrate (e.g., a patterned training substrate). In an embodiment, the process P301 involves accessing a first metrology data set MD1 acquired by a first metrology system TS1 and a second metrology data set MD2 acquired by a second metrology system TS2. For example, accessing a first SEM data set acquired by a first scanning electron metrology (SEM) system and a second SEM data set acquired by a second SEM system. The first metrology data set MD1 (e.g., the first SEM data set) and the second metrology data set MD2 (e.g., the second SEM data set) are associated with the same patterned substrate. In an embodiment, the metrology data sets used for training an ML model may be referred as training data and the patterned substrate may be referred as a training substrate.

In an embodiment, the first metrology data set MD1 and the second metrology data set MD2 may include a set of images (e.g., SEM images) of the patterned substrate (or the training substrate) acquired from the first metrology system TS1 (e.g., a reference metrology system such as a SEM) and the second metrology system TS2 (e.g., another SEM), respectively. Accordingly, the first metrology data set MD1 may be referred as the first SEM image set, and the second metrology data set MD2 may be referred as the second SEM image set. In an embodiment, the first metrology data set MD1 and the second metrology data set MD2 may include contours of features on the patterned substrate. In an embodiment, the contours may be extracted from images (e.g., SEM images) of the patterned substrate. In an embodiment, first contours extracted by the first metrology system TS1 may employ a first extraction algorithm (e.g., an unknown algorithm with fixed or untunable parameters), and second contours extracted by the second metrology system TS2 may employ a second extraction algorithm (e.g., a known algorithm having tunable parameters), different from the first algorithm. In an embodiment, the first metrology data set MD1 and the second metrology data set MD2 may include physical characteristics (e.g., CD, overlay, etc.) associated with patterns on the patterned substrates.

In an embodiment, the first metrology system may output CD measurements, while the implementation details (e.g., algorithms, image processing, etc.) used for determining CD measurements may be unknown. The present disclosure provides mechanisms (e.g., generating converted images by a trained ML model) to adjust one or more parameters of the second metrology system to match the CD measurements from the first metrology system. For example, if SEM images captured using the second metrology system are different from the first metrology system, simply tuning the parameters of the second metrology systems may not achieve satisfying CD-to-CD matching results. However, converting the captured images of the second metrology system using the trained ML model herein, and tuning parameters (e.g., CD threshold values) based on such converted images can advantageously achieve a desired CD-to-CD matching, or other measurement matching results.

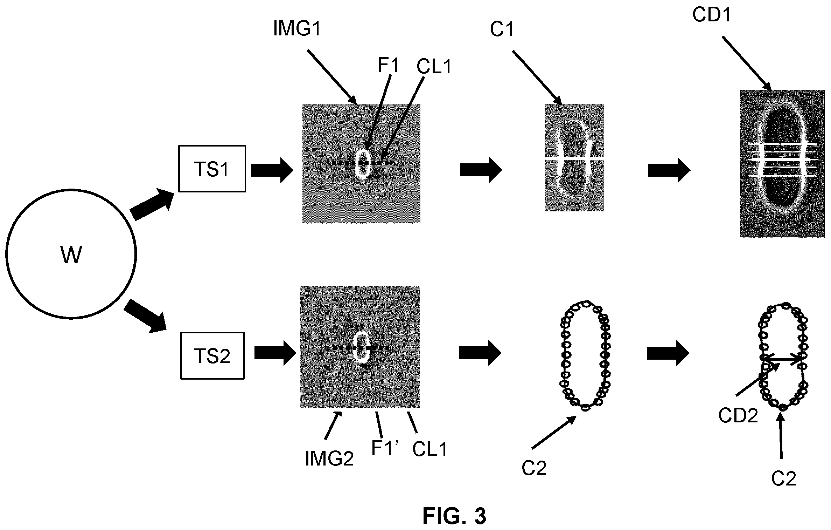

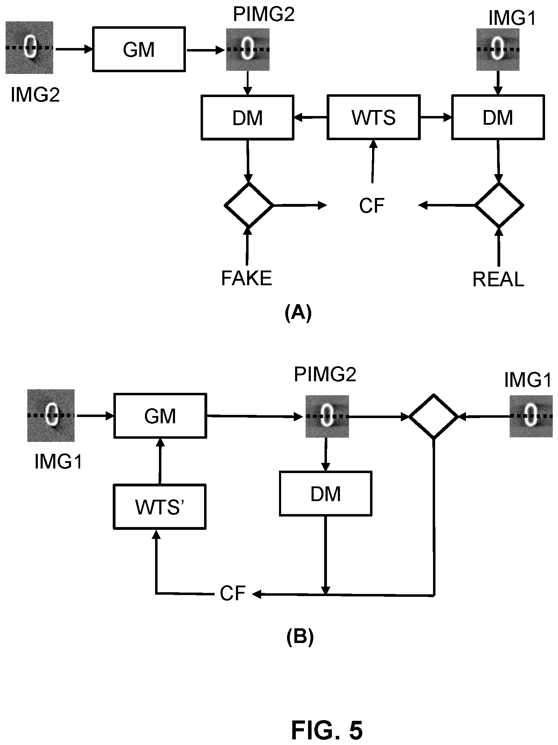

Figure 3 illustrates exemplary metrology data of a patterned substrate W acquired by a first metrology system TS1 and a second metrology system TS2, according to an embodiment. In the present example, the first metrology system TS1 may be a reference metrology system e.g., a first SEM. The first metrology system TS1 may capture a first image IMG1 (e.g., a SEM image) of the patterned substrate W or a portion of the patterned substrate W. As an example, the SEM image IMG1 comprises a feature F1 (represented by a light colored oval shaped portion in the image IMG1) corresponding to a feature (e.g., F, not marked on substrate W) patterned on the substrate W. In an embodiment, a cutline CL1 may be drawn across the feature F1 to measure intensity values of the pixels along the cutline CL1. These intensity values are represented as a first signal S1 (see Figure 5).

Similarly, the second metrology system TS2 may be another metrology system e.g., a second SEM, different from the first SEM. The second metrology system TS2 may capture a second image IMG2 (e.g., another SEM image) of the patterned substrate W or a portion of the patterned substrate W. For example, the SEM image IMG2 comprises a feature F1' (represented by a light colored oval shaped portion in the image IMG2) corresponding to the same feature (e.g., F, not marked on the substrate W) patterned on the substrate W. In an embodiment, a cutline CL1 may be drawn across the feature F1' to measure intensity values of the pixels along the cutline CL1. These intensity values are represented as a second signal S2 (see Figure 5).

In Figure 5, comparing the first signal S1 and the second signal S2 for the same feature patterned on the substrate W indicates that the first metrology system TS1 and the second metrology system TS2 may produce different measurements for the same feature. For example, when a CD is measured along the cutline CL1 based on the first signal S1, the measured CD will be different from the CD measured based on the second signal S2. As an example, the CD may be measured based on a CD threshold defined as a function of distance between adjacent peaks in the signal. In some embodiments, the systems may have different design configurations (e.g., different product models) as supplied by the same or different manufactures. The difference in the signals for the same feature may be associated with structural differences in the tool (such as the system difference as designed in mechanical, electrical and electronic configurations, etc.), difference in algorithms in employed by the systems TS1 and TS2 (such as signal acquisition mechanisms, signal processing algorithms, image enhancement mechanisms, etc.), difference in recipes employed during the measurement for each system TS1 and TS2 (such as contour extraction algorithms, cutline placement algorithms, etc.), or other know or unknown differences between the systems TS1 and TS2. In some embodiments, the systems may have the same design configuration (e.g., the same product model), and the measurement difference may be ascribed to unintended system variation caused by variations in manufacturing, assembly, and/or system drift, etc.

Referring back to Figure 3, a contour C1 corresponding to the feature F1 in the image IMG1 may be extracted. In an embodiment, the contour C1 may be extracted using a first algorithm implemented in the first metrology system TS1. In an embodiment, implementation details of the first contour extraction algorithm may be unknown or fixed, as such parameters within the algorithm may not be adjustable when extracting the contour C1. In an embodiment, a metrology system configuration may be fixed as it is treated as references, and knowledge of specific differences or causes of the differences may not be needed. In an embodiment, such contour C1 may be used as the first metrology data. Similarly, another contour C2 corresponding to the feature F1' in the image IMG2 may be extracted. In an embodiment, the contour C2 may be extracted using a second algorithm implemented in the second metrology system TS2. In an embodiment, the implementation details of the extraction algorithm may be known and one or more parameters (e.g., intensity thresholds characterizing an edge of a feature, extraction model parameters such as Gaussian sigma, etc.) of the second algorithm may be adjustable during adjusting the contour.

In an embodiment, based on the extracted contour C1, values of characteristics such as CD of the feature F1 may be determined. In an embodiment, the CD may be determined based on averaging of distance between two ends along a length of the feature F1. Similarly, based on the extracted contour C2, values of the physical characteristics such as CD of the feature F1' may be determined. In an embodiment, same algorithms may be used to determined CD values of the features F1 and F1'. The present disclosure is not limited to a particular measurement method. For example, the CD may be measured in a linear mode or threshold mode of the metrology systems. In another example, maximum, minimum, or average values of a few neighboring locations of a feature may be used to determine CD values. In yet another example, a shape fitting of contours C1 and C2 may be performed. In yet another example, parameters such as intensity thresholds, signal smoothing window sizes, starting point to find edge locations of a feature, or other tunable parameters may be performed for desired CD-to-CD match results.

The present disclosure is not limited to extracting measurements using a particular technique. The CD measurements determined based on contour extraction and adjustment algorithm only exemplary and does not limit the scope of the present disclosure. In an embodiment, the metrology systems may employ an image processing algorithm and/or a CD measurement algorithm to determine CD of a feature without extracting, from an image, contours of features patterned on the substrate.

However, due to the inherent differences in the images IMG1 and IMG2 from which the contours C1 and C2, respectively, are derived, the measured CDs of the same feature patterned on the substrate W will be different.

In the present disclosure, the trained ML model is configured to convert the second metrology data (e.g., the second signal S2) such that it closely matches the first metrology data (e.g., the first signal S1). Thus, any measurements made using the converted metrology data (e.g., a converted version of the second signal S2) may have similar measurements.

Referring back to Figure 2, process P303 involves training a ML model based on the first metrology data set MD1 and the second metrology data set MD2. After completing the training process, the trained ML model TML is configured to convert a metrology data set acquired by the second metrology system to a converted data set having characteristics as if acquired by the first metrology system TS1 (e.g., the reference metrology system).

In an embodiment, training the ML model involves comparing the first metrology data set MD1 and the second metrology data set MD2 of the patterned training substrate. Based on the comparison, parameters of the ML model may be adjusted to influence a cost function used to train the ML model. For example, the cost function may be a function of a difference between the first and second metrology data sets MD1 and MD2. As the ML model parameters (e.g., weights) are adjusted, the cost function value (e.g., a difference value) is gradually reduced. In an embodiment, the cost function is minimized. In an embodiment, the adjusting of the ML model parameters is stopped when a given number of iterations is reached, when the cost function value is within a desired threshold, when the cost function value does not decrease significantly in subsequent iterations, or other stopping criteria.

In an embodiment, training the ML model is performed to obtain CD-CD or signal to signal matching between the first SEM data set and the second SEM data set. For example, training the ML model involves comparing first CD values of the first SEM data set and second CD values of the second SEM data set; and adjusting parameters of the ML model based on the comparison to influence a cost function used to train the ML model to improve CD matching between the first and the second SEM data sets, the cost function being a function of the first CD values and the second CD values.

In an embodiment, training of the ML model involves using training data set comprising metrology data aligned with a same design layout. For example, a first image set (e.g., first SEM image) of the first metrology data set MD1 may be aligned with a design layout image. As another example, first contours may be aligned with design contours of the design layout. Similarly, a second image set (e.g., another SEM image) of the second metrology data set MD2 may be with the design layout image, or second contours may be aligned with the design contours of the design layout. In an embodiment, the aligned first image set (or aligned first contours) and the aligned second image set (or aligned second contours) may be used as training data to train the ML model.

As an example, training the ML model involves comparing intensity values from the first image set and the second image set, and adjusting parameters of the ML model based on the comparison to influence the cost function used to train the ML model. In an embodiment, intensity values of each pixel of the first image set may be compared with intensity values of corresponding pixels of the second image set.

In an embodiment, training the ML model is an iterative process. Each iteration involves (i) converting the second metrology data set MD2 using the ML model with the adjusted parameters to a converted metrology data set MD2'; (ii) comparing the intensity values from the first metrology data set MD1 and the converted metrology data set MD2'; (iii) further adjusting parameters of the ML model based on the comparison to influence the cost function (e.g., to be within the desired threshold, or minimized); (iv) determining whether the cost function is within the desired threshold (or minimized); and (v) responsive to the cost function not being within the desired threshold (or minimized), repeating steps (i)-(iv).

In an embodiment, the cost function may include a difference between the metrology data sets MD1 and MD2. For example, the cost function may include a difference between a first intensity values from the first metrology data set MD1 and corresponding second intensity values from the second metrology data set MD2 or the converted data set MD2'. In an embodiment, the intensity values may be determined along a cutline drawn across a feature from the first metrology data set MD1 and the second metrology data set MD2. In an embodiment, determining the intensity values comprises determining pixel intensity values along the cutline from the first metrology data set MD1 and the second metrology data set MD2.

In an embodiment, determining the intensity values involves applying a first contour extraction algorithm associated with the first metrology system TS1 on the first metrology data set MD1; and applying a second contour extraction algorithm associated with the second metrology system TS2 on the second metrology data set MD2.

In an embodiment, the process P303 of training the ML model employs a generative adversarial network. In this example, the training process involves training a generator model in conjunction with the discriminator model. The generator model may be trained using the second metrology data set MD2 as input to generate data similar to the first metrology data set MD1; and training the discriminator model to differentiate the generated data from the first metrology data set MD1. The generator model and the discriminator model may be trained in cooperation with each other so that the generator model generates realistic data (e.g., matching reference data), while the discriminator model classifies such generator model data as probably non-realistic.

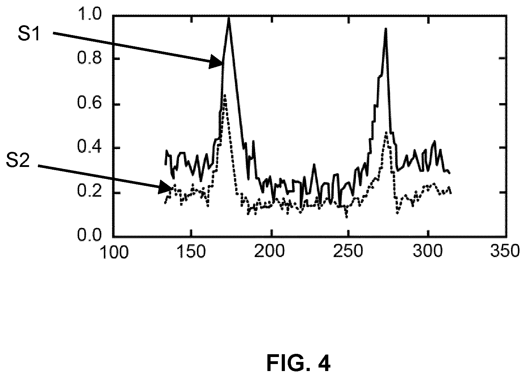

An exemplary training process of GAN is an iterative process. Each training iteration may involve a step (i) for randomly choosing training samples (e.g., a few aligned images IMG1 and IMG2 in Figure 4) from the training data (e.g., MD2 and MD1), and a step (ii) for training the generator model to convert chosen input data from MD2 into converted data MD2' and training the discriminator model using the converted data MD2' and reference data MD1. A cost function for training the discriminator model can be configured to adjust weights of the discriminator model such that the discriminator model classifies the converted data MD2' as false (or fake) and the reference data MD1 as true (or real). For example, the discriminator related cost function may maximize the probability assigned to real and fake images. A cost function for the generator model may include two parts, for example, configured to minimize a probability of generator output to be classified as false by the discriminator. A first part may include a term configured that causes the discriminator model to label the converted data MD2' as true (or real). A second part may include a term such as an intensity difference per pixel between images MD2' and MD1. The second part may be reduced (e.g., minimized) to cause the generator model to generate realistic converted data MD2'. The training process (e.g., steps (i) and (ii)) above are repeated until a desired result is obtained.

Figure 5 illustrates an exemplary training of the ML model using a generative adversarial network (GAN), according to an embodiment. As an example, the ML model comprises a generator model GM and a discriminator model DM. The generator model GM may be configured to receive metrology data as input and generate data similar to reference data. For example, the generator model GM is configured to receive metrology data (e.g., the SEM image IMG2 or contours) acquired by the second metrology system (e.g., TS2 in Figure 3), and generate metrology data (e.g., PIMG2 or contours). In an embodiment, the generated metrology data has characteristics (e.g., intensity, shape of a feature, size of a feature, etc.) as if the generated metrology data was acquired by the first metrology system (e.g., TS1 in Figure 3). The discriminator model DM is configured to receive the generated data outputted by the generator model GM and determine whether the generator data is similar to the reference data. For example, the discriminator model DM is configured to receive the generated metrology data (e.g., PIMG2) and determine whether the generated metrology data (e.g., PIMG2) is similar to the reference data (e.g., the SEM image IMG1). During the training process, the generator model GM and the discriminator model DM compete against each other such that generator model GM progressive generates realistic images and the discriminator model tries to classify these generated images as false (fake).

In the example shown in Figure 5(A), the discriminator model DM may be trained using the generated second image PIMG2 as input and the first image IMG1 of the substrate (e.g., W in Figure 3) as the reference data. In an embodiment, the discriminator model DM classifies the inputted image into a first category (e.g., labelled as REAL) or a second category (e.g., labeled as FAKE). For example, the first category refers to the reference data and the second category refers to data generated by a model (e.g., GM). In an embodiment, weights WTS of the discriminator model DM may be adjusted until the DM model determines the generated image PIMG2 as REAL. In an embodiment, REAL refers to a label assigned by the discriminator model DM to the generated image PIMG2, where REAL indicates that the generated image PIMG2 is similar to the first image IMG1. In an embodiment, the adjustment of the weights WTS of the discriminator model DM is guided by a cost function CF. In an embodiment, the cost function CF may be a function of a difference between the first image IMG1 and the generated image PIMG2. In an embodiment, the difference may be characterized by labels (e.g., real vs fake, intensity differences in images, etc.).

In the example shown in Figure 5(B), the generator model GM may be trained using the second image IMG2 of the substrate (e.g., W in Figure 3) as input and the first image IMG1 of the substrate (e.g., W in Figure 3) as the reference data. In an embodiment, the generator model GM converts the inputted image (e.g., IMG2) to an image PIMG2 that has characteristics (e.g., image intensities, intensity slope, or other image characteristics) similar to the reference data (e.g., IMG1).

In an embodiment, weights WTS' of the generator model GM may be adjusted based on the cost function CF. In an embodiment, the cost function CF may be a function of a difference between the first image IMG1 and the generated image PIMG2, and whether the discriminator model DM classifies the generated image PIMG2 into the second category or the first category. In an embodiment, the cost function guides the adjustment of the weights WTS' of the generator model GM such that the difference between the images PIMG2 and IMG1 is reduced (in an embodiment, minimized), and the generated image PIMG2 is classified by the discriminator model DM into the first category (e.g., REAL).

In an embodiment, the trained ML model TML may be applied to convert captured metrology data by a metrology tool for which the ML model is trained. As an example, the method 300 may further involve processes P305 and P307. Process P305 involves capturing, via the second metrology system TS2, metrology data 310 of a patterned substrate (e.g., different from the substrate used for training the ML model). Process P307 involves converting, via the trained ML model TML, the captured metrology data 310 into converted metrology data 311. The converted metrology data 311 of the patterned substrate has characteristics as if captured by the first metrology system TS1.

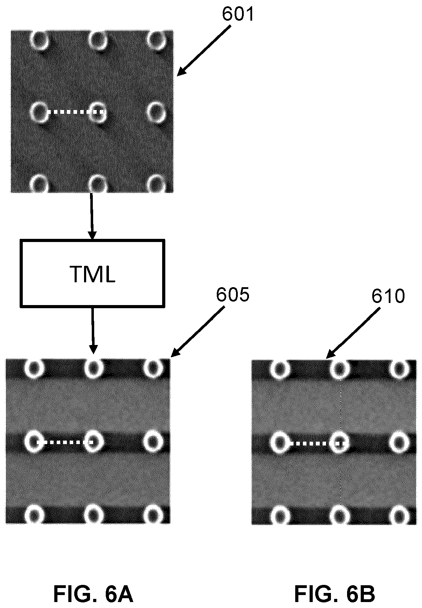

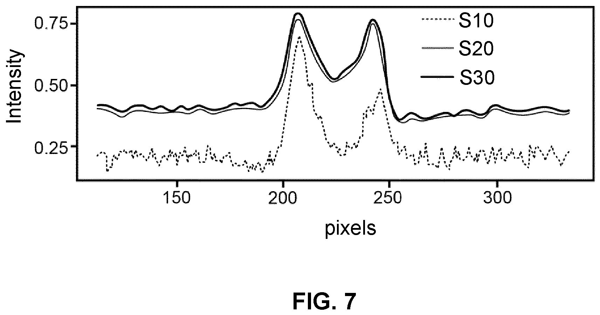

Figure 6A illustrates inputting a second image 601 acquired by a second metrology system (e.g., TS2) to the trained ML model TML (e.g., trained according to method 300) to generate a converted image 605, according to an embodiment. Figure 6B shows an exemplary first image 610 acquired by the first metrology system. The first image 610 and the second image 601 are associated with the same substrate. Comparing the converted image 605 and the first image 610 indicates that these images closely match each other. For example, Figure 7 illustrates signals (e.g., intensity values) along a cutline drawn across a feature in each of the image 601, 605, and 610. Comparing signal S10 obtained from the second image 601 (in Figure 6A) and signal S30 obtained from the first image 610 shows a substantial difference in intensity values. On the other hand, the signal S20 obtained from the converted image 605 and the signal S30 closely match each other. For example, whether the signals match closely may be determined by taking a difference between the signals. Thus, advantageously the converted image 605 can be used for making measurements associated with physical characteristics of features in the image 605.

In an embodiment, metrology recipe may be determined based on the first metrology data acquired from the first metrology system TS1. The metrology recipe may be further used on the converted metrology data obtained from the trained ML model TML to determine measurements of physical characteristics (e.g., CD, overlay, etc.) of patterns on the patterned substrate. As an example, the method 300 may further involve processes P307 and P311. Process P309 involves determining a metrology measurement recipe 315 for the second metrology system TS2 based on the first metrology data set MD1 and physical characteristic measurements PC1 of the patterned substrate from the first metrology system TS1. For example, the metrology measurement recipe 315 comprises CD threshold values indicative of locations on the captured metrology data 311 where CD measurements be taken. In an embodiment, determining the metrology measurement recipe 315 involves extracting, via a first contour extraction algorithm, a contour from an image of the first metrology data set MD1; measure a CD across a cutline (e.g., lines CL1 in Figure 3) at a location across the contour; and determining, based on a signal (e.g., the first signal S1 in Figure 4) along the cutline, CD threshold value corresponding to the measured CD.

In an embodiment, metrology data (e.g., 310) of the patterned substrate may be captured using the second metrology system TS2 and the captured metrology data (e.g., 311) may be converted using the trained ML model TML. Process P311 may be performed on the converted metrology data 311. The process P311 involves applying the metrology measurement recipe 315 to the converted metrology data 311 for determining physical characteristics measurements PC2 of the patterned substrate. For example, the physical characteristics measurements PC2 may be critical dimension (CD) measurements, overlay measurements, edge placement errors, or other characteristics associated with the patterned substrate.

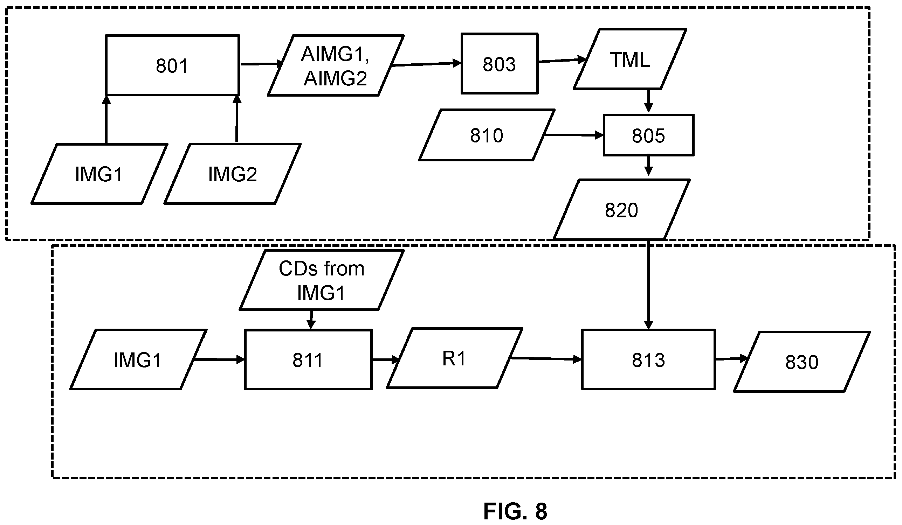

Figure 8 is a block diagram of exemplary operations performed for converting metrology data and determining measurements using the converted metrology data, according to an embodiment. For example, metrology data acquired by a metrology system (e.g., SEM) is converted to match the measurement behavior of the reference metrology system. In an embodiment, an operation 801 involves obtaining training data for training a ML model, where the ML model converts metrology data to be comparable to metrology data being acquired by the reference metrology tool. In an embodiment, the training data includes metrology data sets of a patterned substrate (e.g., a training substrate) obtained as discussed with respect to the process P301 (in Figure 3). For example, the metrology data sets comprise images IMG1 and IMG2 acquired from the first metrology system TS1 and the second metrology system TS2, respectively. In an embodiment, the images IMG1 and IMG2 may be aligned with a design layout to generate aligned images AIMG1 and AIMG2 to be used as training data.

At operation 803, the training data is used for training the ML model. The ML model may be trained according to the process P303 (in Figure 3). After training, the trained ML model TML is obtained.

At operation 805, metrology data 810 (e.g., SEM images or contours) of a patterned substrate to be measured may be obtained. For example, the metrology data 810 is obtained from a metrology system other than the reference metrology system. Further, the metrology data 810 may be inputted to the trained ML model TML to convert the metrology data 810 to converted data 820.

At operation 811, reference metrology data (e.g., IMG1) and reference measurements (e.g., CD values associated with the IMG1) may be obtained from the reference metrology system. Based on this data, metrology recipe R1 may be determined. For example, metrology recipe includes a CD threshold to be applied to a signal along a cutline across a feature in the image IMG1 to determine a CD value of the feature.

At operation 813, the metrology recipe R1 may be applied to the converted metrology data 820 to determine measurements 830 of physical characteristics (e.g., CD) of the patterned substrate. As the converted metrology data is comparable to being acquired by the reference metrology system and the measurement recipe R1 also corresponds to the reference metrology system, the measurements 830 will be comparable to being acquired by the reference metrology tool. Thus, advantageously, a combination of the converted metrology data 820 and the metrology recipe R1 provides measurements consistent with the reference metrology system.

The inspection apparatus or the metrology apparatus may be a scanning electron microscope (SEM) that yields an image of a structure (e.g., some or all the structure of a device) exposed or transferred on the substrate. Figure 9 depicts an embodiment of a SEM tool. A primary electron beam EBP emitted from an electron source ESO is converged by condenser lens CL and then passes through a beam deflector EBD1, an E x B deflector EBD2, and an objective lens OL to irradiate a substrate PSub on a substrate table ST at a focus.

When the substrate PSub is irradiated with electron beam EBP, secondary electrons are generated from the substrate PSub. The secondary electrons are deflected by the E x B deflector EBD2 and detected by a secondary electron detector SED. A two-dimensional electron beam image can be obtained by detecting the electrons generated from the sample in synchronization with, e.g., two dimensional scanning of the electron beam by beam deflector EBD1 or with repetitive scanning of electron beam EBP by beam deflector EBD1 in an X or Y direction, together with continuous movement of the substrate PSub by the substrate table ST in the other of the X or Y direction.

A signal detected by secondary electron detector SED is converted to a digital signal by an analog/digital (A/D) converter ADC, and the digital signal is sent to an image processing system IPU. In an embodiment, the image processing system IPU may have memory MEM to store all or part of digital images for processing by a processing unit PU. The processing unit PU (e.g., specially designed hardware or a combination of hardware and software) is configured to convert or process the digital images into datasets representative of the digital images. Further, image processing system IPU may have a storage medium STOR configured to store the digital images and corresponding datasets in a reference database. A display device DIS may be connected with the image processing system IPU, so that an operator can conduct necessary operation of the equipment with the help of a graphical user interface.

As noted above, SEM images may be processed to extract contours that describe the edges of objects, representing device structures, in the image. These contours are then quantified via metrics, such as CD. Thus, typically, the images of device structures are compared and quantified via simplistic metrics, such as an edge-to-edge distance (CD) or simple pixel differences between images. Typical contour models that detect the edges of the objects in an image in order to measure CD use image gradients. Indeed, those models rely on strong image gradients. But, in practice, the image typically is noisy and has discontinuous boundaries. Techniques, such as smoothing, adaptive thresholding, edge-detection, erosion, and dilation, may be used to process the results of the image gradient contour models to address noisy and discontinuous images, but will ultimately result in a low-resolution quantification of a high-resolution image. Thus, in most instances, mathematical manipulation of images of device structures to reduce noise and automate edge detection results in loss of resolution of the image, thereby resulting in loss of information. Consequently, the result is a low-resolution quantification that amounts to a simplistic representation of a complicated, high-resolution structure.

So, it is desirable to have a mathematical representation of the structures (e.g., circuit features, alignment mark or metrology target portions (e.g., grating features), etc.) produced or expected to be produced using a patterning process, whether, e.g., the structures are in a latent resist image, in a developed resist image or transferred to a layer on the substrate, e.g., by etching, that can preserve the resolution and yet describe the general shape of the structures. In the context of lithography or other pattering processes, the structure may be a device or a portion thereof that is being manufactured and the images may be SEM images of the structure. In some instances, the structure may be a feature of semiconductor device, e.g., integrated circuit. In this case, the structure may be referred as a pattern or a desired pattern that comprises a plurality of feature of the semiconductor device. In some instances, the structure may be an alignment mark, or a portion thereof (e.g., a grating of the alignment mark), that is used in an alignment measurement process to determine alignment of an object (e.g., a substrate) with another object (e.g., a patterning device) or a metrology target, or a portion thereof (e.g., a grating of the metrology target), that is used to measure a parameter (e.g., overlay, focus, dose, etc.) of the patterning process. In an embodiment, the metrology target is a diffractive grating used to measure, e.g., overlay.

Figure 10 schematically illustrates a further embodiment of an inspection apparatus. The system is used to inspect a sample 90 (such as a substrate) on a sample stage 88 and comprises a charged particle beam generator 81, a condenser lens module 82, a probe forming objective lens module 83, a charged particle beam deflection module 84, a secondary charged particle detector module 85, and an image forming module 86.

The charged particle beam generator 81 generates a primary charged particle beam 91. The condenser lens module 82 condenses the generated primary charged particle beam 91. The probe forming objective lens module 83 focuses the condensed primary charged particle beam into a charged particle beam probe 92. The charged particle beam deflection module 84 scans the formed charged particle beam probe 92 across the surface of an area of interest on the sample 90 secured on the sample stage 88. In an embodiment, the charged particle beam generator 81, the condenser lens module 82 and the probe forming objective lens module 83, or their equivalent designs, alternatives or any combination thereof, together form a charged particle beam probe generator which generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly forming at least one scanned image. In an embodiment, the secondary charged particle detector module 85 and image forming module 86, or their equivalent designs, alternatives or any combination thereof, together form an image forming apparatus which forms a scanned image from detected secondary charged particles emitted from sample 90 being bombarded by the charged particle beam probe 92.

In an embodiment, a monitoring module 87 is coupled to the image forming module 86 of the image forming apparatus to monitor, control, etc. the patterning process and/or derive a parameter for patterning process design, control, monitoring, etc. using the scanned image of the sample 90 received from image forming module 86. So, in an embodiment, the monitoring module 87 is configured or programmed to cause execution of a method described herein. In an embodiment, the monitoring module 87 comprises a computing device. In an embodiment, the monitoring module 87 comprises a computer program to provide functionality herein and encoded on a computer readable medium forming, or disposed within, the monitoring module 87.

In an embodiment, like the electron beam inspection tool of Figure 9 that uses a probe to inspect a substrate, the electron current in the system of Figure 10 is significantly larger compared to, e.g., a CD SEM such as depicted in Figure 9, such that the probe spot is large enough so that the inspection speed can be fast. However, the resolution may not be as high as compared to a CD SEM because of the large probe spot. In an embodiment, the above discussed inspection apparatus may be single beam or a multi-beam apparatus without limiting the scope of the present disclosure.

The SEM images, from, e.g., the system of Figure 9 and/or Figure 10, may be processed to extract contours that describe the edges of objects, representing device structures, in the image. These contours are then typically quantified via metrics, such as CD, at user-defined cut-lines. Thus, typically, the images of device structures are compared and quantified via metrics, such as an edge-to-edge distance (CD) measured on extracted contours or simple pixel differences between images.

In an embodiment, the one or more procedures of the process 300 can be implemented as instructions (e.g., program code) in a processor of a computer system (e.g., process 104 of computer system 100). In an embodiment, the procedures may be distributed across a plurality of processors (e.g., parallel computation) to improve computing efficiency. In an embodiment, the computer program product comprising a non-transitory computer readable medium has instructions recorded thereon, the instructions when executed by a computer hardware system implementing the method described herein.

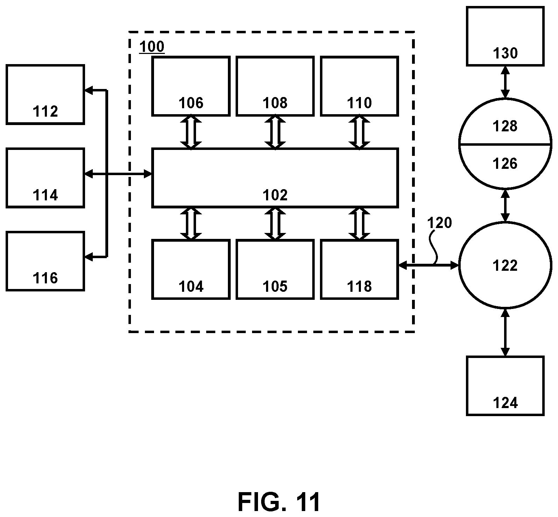

Figure 11 is a block diagram that illustrates a computer system 100 which can assist in implementing the methods, flows or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The descriptions above are intended to be illustrative, not limiting. Thus, it will be apparent to one skilled in the art that modifications may be made as described without departing from the scope of the claims set out below.

## Claims

1. A non-transitory computer-readable medium having instructions recorded thereon, the instructions when executed by a computer implementing a method for converting data associated with a metrology system, the method comprising:
accessing a first scanning electron metrology, SEM, data set acquired by a first SEM system and a second SEM data set acquired by a second SEM system, the first SEM data set and the second SEM data set being associated with a patterned substrate; and
training, using the first SEM data set and the second SEM data set as training data, a machine learning (ML) model such that the trained ML model is configured to convert a metrology data set acquired by the second SEM system to a converted data set having characteristics comparable to metrology data being acquired by the first SEM system.

2. The medium of claim 1, wherein the first SEM data set and the second SEM data set comprises SEM images of the patterned substrate, wherein training the ML model comprises:
comparing first set of images acquired by the first SEM system and second set of images acquired by the second SEM system; and
adjusting parameters of the ML model based on the comparison to influence a cost function used to train the ML model to improve matching between the first set of images and the ML-generated images using the second set of images as input to the ML model.

3. The medium of claim 1, wherein the first SEM data set and the second SEM data set comprises:
contours of features on the patterned substrate; and/or
physical characteristics associated with patterns on the patterned substrates.

4. The medium of claim 3, wherein the physical characteristics comprises critical dimension, CD, of the patterns on the patterned substrate.

5. The medium of claim 1, wherein training the ML model comprises:
comparing first CD values of the first SEM data set and second CD values of the second SEM data set; and
adjusting parameters of the ML model based on the comparison to influence a cost function used to train the ML model to improve CD matching between the first and the second SEM data sets, the cost function being a function of the first CD values and the second CD values.

6. The medium of claim 1, wherein training the ML model comprises:
aligning a first image set or first contours of the first SEM data set with a design layout image or design contours of a design layout;
aligning a second image set or second contours of the second SEM data set with the design layout image or the design contours of the design layout; and
using the aligned first image set and the aligned second image set as training data used to train the ML model.

7. The medium of claim 2, wherein training the ML model comprises:
comparing pixel intensity values from the first image set and the second image set; and
adjusting parameters of the ML model based on the comparison to influence the cost function used to train the ML model.

8. The medium of claim 7, wherein the training the ML model further comprises determining intensity values from the first image set and the second image set by performing:
applying a first contour extraction algorithm associated with the first SEM system on the first SEM data set; and
applying a second contour extraction algorithm associated with the second SEM system on the second SEM data set.

9. The medium of claim 1, further comprising:
capturing, via the second SEM system, metrology data of another patterned substrate; and
converting, via the trained ML model, the captured metrology data into converted metrology data, the converted metrology data of the other patterned substrate having characteristics as if captured by the first SEM system.

10. The medium of claim 1, further comprising:
determining a metrology measurement recipe for the second SEM system based on the first SEM data set and physical characteristic measurements of the patterned substrate from the first SEM system;
capturing metrology data of the patterned substrate using the second SEM system;
converting the captured metrology data using the trained ML model; and
applying the metrology measurement recipe to the converted metrology data to determine another physical characteristics measurements.

11. The medium of claim 10, wherein the physical characteristics measurements comprise at least one of: CD measurements, overlay measurements, and edge placement errors.

12. The medium of claim 10, wherein the metrology measurement recipe comprises CD thresholding values indicative of locations on the captured metrology data where CD measurements be taken.

13. The medium of claim 10, wherein determining the metrology measurement recipe comprises:
extracting, via a first contour extraction algorithm, a contour from an image of the first SEM data set;
drawing a cutline at a location across the contour to measure a CD; and
determining, based on a signal along the cutline, a CD threshold value corresponding to the measured CD.

14. The medium of claim 1, wherein the first SEM system is manufactured by a first manufacturer, and the second metrology system is manufactured by a second manufacturer.

15. The medium of claim 1, wherein the ML model is trained using a generative adversarial Network architecture, the ML model comprising a generator model and a discriminator model.

## Patentansprüche

1. Ein nichttransitorisches, computerlesbares Medium, auf dem Anweisungen aufgezeichnet sind, wobei die Anweisungen bei Ausführung durch einen Computer ein Verfahren zum Konvertieren von mit einem Metrologiesystem assoziierten Daten implementieren, wobei das Verfahren Folgendes beinhaltet:
Zugreifen auf einen ersten Rasterelektronenmetrologie-Datensatz, SEM-Datensatz, der durch ein erstes SEM-System gewonnen wird, und einen zweiten SEM-Datensatz, der durch ein zweites SEM-System gewonnen wird, wobei der erste SEM-Datensatz und der zweite SEM-Datensatz mit einem gemusterten Substrat assoziiert sind; und
unter Verwendung des ersten SEM-Datensatzes und des zweiten SEM-Datensatzes als Trainingsdaten, Trainieren eines Maschinenlernmodells (ML-Modells), sodass das trainierte ML-Modell konfiguriert ist, um einen durch das zweite SEM-System gewonnenen Metrologiedatensatz in einen konvertierten Datensatz zu konvertieren, der Eigenschaften aufweist, die mit durch das erste SEM-System gewonnenen Metrologiedaten vergleichbar sind.

2. Medium gemäß Anspruch 1, wobei der erste SEM-Datensatz und der zweite SEM-Datensatz SEM-Bilder des gemusterten Substrats beinhalten, wobei das Trainieren des ML-Modells Folgendes beinhaltet:
Vergleichen eines ersten Satzes Bilder, die durch das erste SEM-System gewonnen werden, und eines zweiten Satzes Bilder, die durch das zweite SEM-System gewonnen werden; und
Anpassen von Parametern des ML-Modells auf der Basis des Vergleichs, um eine zum Trainieren des ML-Modells verwendete Kostenfunktion zu beeinflussen, um die Übereinstimmung zwischen dem ersten Satz Bilder und den ML-erzeugten Bildern zu verbessern, wobei der zweite Satz Bilder als Eingang für das ML-Modell verwendet wird.

3. Medium gemäß Anspruch 1, wobei der erste SEM-Datensatz und der zweite SEM-Datensatz Folgendes beinhalten:
Umrisse von Merkmalen auf dem gemusterten Substrat; und/oder
physische Eigenschaften, die mit Mustern auf den gemusterten Substraten assoziiert sind.

4. Medium gemäß Anspruch 3, wobei die physischen Eigenschaften eine kritische Abmessung, CD, der Muster auf dem gemusterten Substrat beinhalten.

5. Medium gemäß Anspruch 1, wobei das Trainieren des ML-Modells Folgendes beinhaltet:
Vergleichen von ersten CD-Werten des ersten SEM-Datensatzes und zweiten CD-Werten des zweiten SEM-Datensatzes; und
Anpassen von Parametern des ML-Modells auf der Basis des Vergleichs, um eine zum Trainieren des ML-Modells verwendete Kostenfunktion zu beeinflussen, um die CD-Übereinstimmung zwischen dem ersten und dem zweiten SEM-Datensatz zu verbessern, wobei die Kostenfunktion eine Funktion der ersten CD-Werte und der zweiten CD-Werte ist.

6. Medium gemäß Anspruch 1, wobei das Trainieren des ML-Modells Folgendes beinhaltet:
Ausrichten eines ersten Bildsatzes oder erster Umrisse des ersten SEM-Datensatzes nach einem Entwurfslayoutbild oder Entwurfsumrissen eines Entwurfslayouts;
Ausrichten eines zweiten Bildsatzes oder zweiter Umrisse des zweiten SEM-Datensatzes nach dem Entwurfslayoutbild oder den Entwurfsumrissen des Entwurfslayouts; und
Verwenden des ausgerichteten ersten Bildsatzes und des ausgerichteten zweiten Bildsatzes als Trainingsdaten, die zum Trainieren des ML-Modells verwendet werden.

7. Medium gemäß Anspruch 2, wobei das Trainieren des ML-Modells Folgendes beinhaltet:
Vergleichen von Pixelintensitätswerten aus dem ersten Bildsatz und dem zweiten Bildsatz; und
Anpassen von Parametern des ML-Modells auf der Basis des Vergleichs, um die zum Trainieren des ML-Modells verwendete Kostenfunktion zu beeinflussen.

8. Medium gemäß Anspruch 7, wobei das Trainieren des ML-Modells ferner das Bestimmen von Intensitätswerten aus dem ersten Bildsatz und dem zweiten Bildsatz durch die Durchführung von Folgendem beinhaltet:
Anwenden eines ersten Umrissextraktionsalgorithmus, der mit dem ersten SEM-System assoziiert ist, auf den ersten SEM-Datensatz; und
Anwenden eines zweiten Umrissextraktionsalgorithmus, der mit dem zweiten SEM-System assoziiert ist, auf den zweiten SEM-Datensatz.

9. Medium gemäß Anspruch 1, das ferner Folgendes beinhaltet:
Erfassen, über das zweite SEM-System, von Metrologiedaten eines weiteren gemusterten Substrats; und
Konvertieren, über das trainierte ML-Modell, der erfassten Metrologiedaten in konvertierte Metrologiedaten, wobei die konvertierten Metrologiedaten des weiteren gemusterten Substrats Eigenschaften aufweisen, als ob sie durch das erste SEM-System erfasst worden wären.

10. Medium gemäß Anspruch 1, das ferner Folgendes beinhaltet:
Bestimmen eines Metrologiemessrezeptes für das zweite SEM-System auf der Basis des ersten SEM-Datensatzes und von Messungen physischer Eigenschaften des gemusterten Substrats von dem ersten SEM-System;
Erfassen von Metrologiedaten des gemusterten Substrats unter Verwendung des zweiten SEM-Systems;
Konvertieren der erfassten Metrologiedaten unter Verwendung des trainierten ML-Modells; und
Anwenden des Metrologiemessrezeptes auf die konvertierten Metrologiedaten, um weitere Messungen physischer Eigenschaften zu bestimmen.

11. Medium gemäß Anspruch 10, wobei die Messungen physischer Eigenschaften mindestens eines von Folgendem beinhalten:
CD-Messungen, Overlay-Messungen und Kantenplatzierungsfehler.

12. Medium gemäß Anspruch 10, wobei das Metrologiemessrezept CD-Schwellenwertverfahrenswerte beinhaltet, die für Stellen auf den erfassten Metrologiedaten, an denen CD-Messungen zu nehmen sind, indikativ sind.

13. Medium gemäß Anspruch 10, wobei das Bestimmen des Metrologiemessrezeptes Folgendes beinhaltet:
Extrahieren, über einen ersten Umrissextraktionsalgorithmus, eines Umrisses aus einem Bild des ersten SEM-Datensatzes;
Zeichnen einer Schnittlinie an einer Stelle über den Umriss zum Messen einer CD; und
Bestimmen, auf der Basis eines Signals entlang der Schnittlinie, eines CD-Schwellenwerts, der der gemessenen CD entspricht.

14. Medium gemäß Anspruch 1, wobei das erste SEM-System von einem ersten Hersteller hergestellt ist und das zweite Metrologiesystem von einem zweiten Hersteller hergestellt ist.

15. Medium gemäß Anspruch 1, wobei das ML-Modell unter Verwendung einer Generative-Adversarial-Network-Architektur trainiert wird, wobei das ML-Modell ein Generatormodell und ein Diskriminatormodell beinhaltet.

## Revendications

1. Un support lisible par ordinateur non transitoire sur lequel des instructions sont enregistrées, les instructions implémentant, lorsqu'elles sont exécutées par un ordinateur, un procédé destiné à convertir des données associées à un système de métrologie, le procédé comprenant :
l'accès à un premier ensemble de données de métrologie électronique à balayage, SEM (*Scanning Electron Metrology*), acquis par un premier système SEM et à un deuxième ensemble de données SEM acquis par un deuxième système SEM, le premier ensemble de données SEM et le deuxième ensemble de données SEM étant associés à un substrat à motif ; et
l'entraînement, en utilisant le premier ensemble de données SEM et le deuxième ensemble de données SEM comme données d'entraînement, d'un modèle d'apprentissage machine (ML, *Machine Learning*) de telle sorte que le modèle ML entraîné est configuré pour convertir un ensemble de données de métrologie acquis par le deuxième système SEM en un ensemble de données converti ayant des caractéristiques comparables à des données de métrologie qui sont acquises par le premier système SEM.

2. Le support de la revendication 1, où le premier ensemble de données SEM et le deuxième ensemble de données SEM comprennent des images SEM du substrat à motif, où l'entraînement du modèle ML comprend :
la comparaison d'un premier ensemble d'images acquis par le premier système SEM et d'un deuxième ensemble d'images acquis par le deuxième système SEM ; et
l'ajustement de paramètres du modèle ML sur la base de la comparaison afin d'influer sur une fonction de coût utilisée pour entraîner le modèle ML dans le but d'améliorer une concordance entre le premier ensemble d'images et les images générées par ML en utilisant le deuxième ensemble d'images comme entrée dans le modèle ML.

3. Le support de la revendication 1, où le premier ensemble de données SEM et le deuxième ensemble de données SEM comprennent :
des contours de traits sur le substrat à motif ; et/ou
des caractéristiques physiques associées à des motifs sur les substrats à motif.

4. Le support de la revendication 3, où les caractéristiques physiques comprennent une dimension critique, CD (*Critical Dimension*), des motifs sur le substrat à motif.

5. Le support de la revendication 1, où l'entraînement du modèle ML comprend :
la comparaison de premières valeurs CD du premier ensemble de données SEM et de deuxièmes valeurs CD du deuxième ensemble de données SEM ; et
l'ajustement de paramètres du modèle ML sur la base de la comparaison afin d'influer sur une fonction de coût utilisée pour entraîner le modèle ML dans le but d'améliorer une concordance CD entre les premier et deuxième ensembles de données SEM, la fonction de coût étant une fonction des premières valeurs CD et des deuxièmes valeurs CD.

6. Le support de la revendication 1, où l'entraînement du modèle ML comprend :
l'alignement d'un premier ensemble d'images ou de premiers contours du premier ensemble de données SEM avec une image de tracé de conception ou des contours de conception d'un tracé de conception ;
l'alignement d'un deuxième ensemble d'images ou de deuxièmes contours du deuxième ensemble de données SEM avec l'image de tracé de conception ou les contours de conception du tracé de conception ; et
l'utilisation du premier ensemble d'images aligné et du deuxième ensemble d'images aligné comme données d'entraînement utilisées pour entraîner le modèle ML.

7. Le support de la revendication 2, où l'entraînement du modèle ML comprend :
la comparaison de valeurs d'intensité de pixels provenant du premier ensemble d'images et du deuxième ensemble d'images ; et
l'ajustement de paramètres du modèle ML sur la base de la comparaison afin d'influer sur la fonction de coût utilisée pour entraîner le modèle ML.

8. Le support de la revendication 7, où l'entraînement du modèle ML comprend en sus la détermination de valeurs d'intensité provenant du premier ensemble d'images et du deuxième ensemble d'images en procédant :
à l'application d'un premier algorithme d'extraction de contour associé au premier système SEM sur le premier ensemble de données SEM ; et
à l'application d'un deuxième algorithme d'extraction de contour associé au deuxième système SEM sur le deuxième ensemble de données SEM.

9. Le support de la revendication 1, comprenant en sus :
la capture, via le deuxième système SEM, de données de métrologie d'un autre substrat à motif ; et
la conversion, via le modèle ML entraîné, des données de métrologie capturées en données de métrologie converties, les données de métrologie converties de l'autre substrat à motif ayant des caractéristiques telles que si elles avaient été capturées par le premier système SEM.

10. Le support de la revendication 1, comprenant en sus :
la détermination d'une recette de mesure de métrologie pour le deuxième système SEM sur la base du premier ensemble de données SEM et de mesures de caractéristiques physiques du substrat à motif provenant du premier système SEM ;
la capture de données de métrologie du substrat à motif en utilisant le deuxième système SEM ;
la conversion des données de métrologie capturées en utilisant le modèle ML entraîné ; et
l'application de la recette de mesure de métrologie aux données de métrologie converties pour déterminer d'autres mesures de caractéristiques physiques.

11. Le support de la revendication 10, où les mesures de caractéristiques physiques comprennent au moins un élément parmi :
des mesures CD, des mesures d'overlay, et des erreurs de placement de bord.

12. Le support de la revendication 10, où la recette de mesure de métrologie comprend des valeurs de seuillage CD indicatives d'emplacements sur les données de métrologie capturées où prendre des mesures CD.

13. Le support de la revendication 10, où la détermination de la recette de mesure de métrologie comprend :
l'extraction, via un premier algorithme d'extraction de contour, d'un contour provenant d'une image du premier ensemble de données SEM ;
le tirage d'une ligne de coupe au niveau d'un emplacement au travers du contour pour mesurer une CD ; et
la détermination, sur la base d'un signal le long de la ligne de coupe, d'une valeur de seuil CD correspondant à la CD mesurée.

14. Le support de la revendication 1, où le premier système SEM est fabriqué par un premier fabricant, et le deuxième système de métrologie est fabriqué par un deuxième fabricant.

15. Le support de la revendication 1, où le modèle ML est entraîné en utilisant une architecture de réseau antagoniste génératif, le modèle ML comprenant un modèle générateur et un modèle discriminateur.
